# EUROPÄISCHE PATENTSCHRIFT

(11) **EP 1 277 237 B1**
(45) Veröffentlichungstag und Bekanntmachung des Hinweises auf die Patenterteilung: **15.09.2010**
(21) Anmeldenummer: 00987007.2
(22) Anmeldetag: 20.10.2000
(51) Int. Cl.: H01L 31/18, H01L 21/00, H01L 21/324

(54) **Vorrichtung und Verfahren zum Temperieren mindestens eines Prozessierguts**
Device and method for tempering at least one process good
Procédé et dispositif pour recuire au moins un élément à traiter

(30) Priorität: 20.10.1999 DE 19950575
(43) Veröffentlichungstag der Anmeldung: 22.01.2003
(73) Patentinhaber: Saint-Gobain Glass France S.A., 92400 Courbevoie (FR)
(72) Erfinder: PROBST, Volker, 81547 München (DE)
(74) Vertreter: Lendvai, Tomas
(86) Internationale Anmeldenummer: PCT/DE2000/003719
(87) Internationale Veröffentlichungsnummer: WO 2001/029901

(56) Entgegenhaltungen:
- EP-A- 0 399 662
- EP-A- 0 926 719
- WO-A-94/07269
- US-A- 5 861 609
- KARG F ET AL: "Novel rapid-thermal-processing for CIS thin-film solar cells" , PROCEEDINGS OF THE PHOTOVOLTAIC SPECIALISTS CONFERENCE. LOUISVILLE, MAY 10 - 14, 1993, NEW YORK, IEEE, US, VOL. CONF. 23, PAGE(S) 441-446 XP010113365 ISBN: 0-7803-1220-1 das ganze Dokument
- PATENT ABSTRACTS OF JAPAN vol. 1995, no. 06, 31. Juli 1995 (1995-07-31) & JP 07 078830 A (HITACHI LTD), 20. März 1995 (1995-03-20)
- PATENT ABSTRACTS OF JAPAN vol. 010, no. 319 (E-450), 30. Oktober 1986 (1986-10-30) & JP 61 129834 A (DAINIPPON SCREEN MFG CO LTD), 17. Juni 1986 (1986-06-17)

## Beschreibung

Die Erfindung betrifft eine Vorrichtung zum Temperieren mindestens eines Prozessierguts in einem Temperierraum eines Temperierbehälters unter einer bestimmten Prozeßgasatmosphäre mindestens eines Prozeßgases. Eine derartige Vorrichtung ist beispielsweise aus EP 0 662 247 B1 bekannt. Neben der Vorrichtung wird ein Verfahren zum Temperieren eines Prozessierguts vorgestellt.

Das aus EP 0 662 247 B1 bekannte Prozessiergut ist ein Mehrschichtkörper, der dadurch hergestellt wird, daß auf eine Trägerschicht (Substrat) eine funktionelle Schicht aufgebracht wird. Damit die funktionelle Schicht und/oder die Trägerschicht eine gewünschte physikalische (elektrisch, mechanisch, etc.) und/oder chemische Eigenschaft aufweist, wird ein Prozessieren des Prozessierguts bzw. der Schicht und/oder der Trägerschicht durchgeführt. Das Prozessieren beinhaltet ein Temperieren des Prozessierguts in Gegenwart eines Gases (Prozeßgas).

Aus EP 0 926 719 A2 ist eine Vorrichtung zur Wärmebehandlung eines SOI-Substrates (SOI = semiconductor on isolator) mit einem Silizium-Einkristall auf der Oberfläche oder mehrere solcher Substrate bekannt.

Zum Temperieren wird das Prozessiergut in einem geschlossenen Temperierbehälter aus Graphit angeordnet. Während des Temperierens ist das Prozessiergut einem Prozeßgas mit gasförmigem Selen ausgesetzt. Beim Temperieren nimmt das Prozessiergut eine Energiemenge auf, wobei jeder Schicht eine Teilmenge der Energiemenge zugeführt wird. Das Temperieren erfolgt beispielsweise mit einer Aufheizrate von 10°C/s. Als Energiequelle der Energiemenge wird eine Halogenlampe benutzt. Mit der Halogenlampe wird der Temperierbehälter aus Graphit mit einer elektromagnetischen Strahlung bestrahlt und somit der Temperierbehälter aufgeheizt. Graphit weist ein hohes Absorptionsvermögen für die elektromagnetische Strahlung im Spektralbereich der Halogenlampe auf. Die durch das Graphit absorbierte Energiemenge wird durch Wärmestrahlung und/oder Wärmeleitung dem Prozessiergut zugeführt. Der Temperierbehälter fungiert somit als sekundäre Energiequelle bzw. als Energietransmitter.

Graphit weist ein hohes Emissionsvermögen und eine hohe Wärmeleitfähigkeit auf. Bei Aufliegen des Prozessierguts auf einem Boden des Temperierbehälters erfolgt die Zufuhr der Energiemenge auf einer Unterseite des Prozessierguts im wesentlichen durch Wärmeleitung. Einer Oberseite des Prozessierguts wird eine Energiemenge durch Wärmestrahlung, Wärmeleitung und Konvektion zugeführt.

Je größer (großflächiger) das Prozessiergut ist, je unterschiedlicher die im Prozessiergut verwendeten Materialien sind (z.B. stark unterschiedlicher Temperaturausdehnungskoeffizient, unterschiedliches Absorptionsvermögen für die Energiemenge etc.) und je höher eine Temperierrate ist (Aufheizrate, Abkühlrate), desto schwieriger ist es, eine Temperaturhomogenität bzw. Temperaturinhomogenität im Prozessiergut zu steuern. Die Temperaturinhomogenität kann zu einer mechanischen Spannung im Prozessiergut und damit zur Zerstörung des Prozessierguts führen.

Ein Problem, das sich aus dem zitierten Stand der Technik ergibt, besteht in einer Verwendung bzw. in einem Auftreten von toxischen und/oder korrosiven Gasen bei Temperieren (z.B. H₂Se).

Aufgabe der Erfindung ist es, aufzuzeigen, wie auch in Gegenwart toxischer und/oder korrosiver Gase eine sicheres und zuverlässiges Temperieren durchgeführt werden kann.

Zur Lösung der Aufgabe wird eine Vorrichtung zum Temperieren mindestens eines Prozessierguts unter einer bestimmten Prozessgasatmosphäre mindestens eines Prozessgases mit Hilfe einer Temperiereinheit, aufweisend mindestens eine Energiequelle zur Aufnahme einer Energiemenge durch das Prozessiergut, einen Temperierbehälter mit Temperierraum zum Aufbewahren des Prozessiergutes unter der Prozessgasatmosphäre während des Temperierens wobei der Temperierbehälter in einer Umhüllung vorliegt, so dass ein Pufferraum für Gas zwischen Umhüllung und Temperierbehälter vorhanden ist, eine Temperierkammer, in der in einem Abstand zur Temperierkammer der Temperlerbehälter angeordnet ist, so dass ein Zwischenraum der den Temperierraum umschließt zwischen Temperierbehälter und Temperierkammer vorhanden ist, und ein Mittel zum Herstellen einer von der Prozessgasatmosphäre verschiedenen weiteren Gasatmosphäre eines weiteren Gases In dem Zwischenraum, wobei die weitere Gasatmosphäre einen Druckgradienten aufweist, so dass der Gasdruck des Temperierraums (16) kleiner ist als der Gasdruck des Zwischenraums (14) und wobei der Temperierbehälter (11) und der Pufferraum (15) durch einen Spalt (8) des Temperierbehälters (11) verbunden sind, durch den das Prozessgas (4) in den Pufferraum (15) austreten kann, und der Zwischenraum (14) und der Pufferraum (15) durch einen Spalt (9) der Umhüllung (12) verbunden sind, und wobei der Pufferraum (15) mit einer Umgebung (7) derart verbunden ist, dass der Gasdruck des Pufferraums (15) einem Gasdruck der Umgebung (7) entspricht und der Gasdruck des Pufferraums (15) so eingestellt werden kann, dass er kleiner ist als der Gasdruck des Temperierraums (16) und kleiner als der Gasdruck des Zwischenraums (14).

Es wird eine Vorrichtung zum Temperieren mindestens eines Prozessierguts unter einer bestimmten Prozeßgasatmosphäre mindestens eines Prozeßgases mit Hilfe einer Temperiereinheit angegeben. Die Temperiereinheit weist auf mindestens eine Energiequelle zur Aufnahme einer Energiemenge durch das Prozessiergut, einen Temperierbehälter mit Temperierraum zum Aufbewahren des Prozessiergutes unter der Prozeßgasatmosphäre während des Temperierens, eine Temperierkammer, in der in einem Abstand zur Temperierkammer der Temperierbehälter angeordnet ist, so daß ein Zwischenraum zwischen Temperierbehälter und Temperierkammer vorhanden ist, und ein Mittel zum Herstellen einer von der Prozeßgasatmosphäre verschiedenen weiteren Gasatmosphäre eines weiteren Gases in dem Zwischenraum. Die weitere Gasatmosphäre weist dabei einen Druckgradienten auf.

Die (einstellbare) weitere Gasatmosphäre zeichnet sich beispielsweise durch einen definierten Partialdruck eines Gases oder Gasgemisches (z.B. Luft) aus. Denkbar ist auch, daß die Gasatmosphäre ein Vakuum ist. Mit Hilfe des Zwischenraums wird vermieden, daß Prozeßgas in die Umgebung (Atmosphäre) abgegeben wird. Dazu umschließt der Zwischenraum den Temperierraum.

Das Mittel zum Herstellen der weiteren Gasatmosphäre ist beispielsweise eine Gasflasche, die mit dem Zwischenraum über eine oder mehrere Öffnungen in Verbindung steht. Denkbar ist auch eine Vakuumpumpe. Mit beiden Mitteln kann ein Druckgradient im Zwischenraum hergestellt werden.

In der Erfindung ist mindestens eine Temperiereinheit vorhanden mit einer Energiequelle zur Aufnahme einer Energiemenge durch das Prozessiergut.

Die Energiequelle ist beispielsweise eine Heizerebene, die von einem Heizerarray gebildet ist. Das Heizerarray besteht beispielsweise aus parallel zueinander angeordneten stabförmigen Halogenlampen oder Heizstäben. Jede Halogenlampe kann dabei in einer Umhüllung angeordnet sein zum Schutz vor einem Einwirken des (korrosiven) Prozeßgases oder zur leichten Montage und Demontage. Eine derartige Energiequelle sendet elektromagnetische Strahlung insbesondere in Form von Infrarotstrahlung (Wärmestrahlung, Intensitätsmaximum bei einer Wellenlänge zwischen 1 µm und 2 µm). Denkbar ist auch eine Energiequelle in Form eines Widerstandsheizelements, das Wärmestrahlung aussendet. Ein derartiges Element weist beispielsweise Graphit, Siliziumkarbid und/oder eine Metall-Legierung wie Nickel-Chrom auf. Denkbar ist darüber hinaus jede elektromagnetische Strahlung (Mikrowellen, UV-Licht), die zu einer Aufheizung des Prozessierguts führen kann. Darüber hinaus sind für das Temperieren auch Wärmeleitung und Konvektion denkbar.

In einer weiteren Ausgestaltung weist die Temperiereinheit mindestens ein Mittel zum Kühlen des Prozessierguts auf. Damit verbindet sich der Vorteil, daß ein Prozeßablauf umfassend verschiedene Verfahrensstufen mit mindestens einer Aufheizphase und Abkühlphase mit Hilfe der gleichen Vorrichtung durchgeführt werden kann. Das Mittel zum Kühlen ist insbesondere ein Kühlgas und/oder eine Kühlflüssigkeit. Das Kühlen erfolgt mit Hilfe des Kühlgases durch Konvektion, wobei beispielsweise ein im Vergleich zum Prozessiergut kühleres Kühlgas am Prozessiergut vorbeigeleitet wird. Das Kühlen kann auch durch Wärmeleitung erfolgen, wobei das Prozessiergut mit einem Kühlkörper mit einem entsprechenden Temperaturleitfähigkeitskoeffizienten in Kontakt steht. Denkbar ist, das der Kühlkörper eine Ummantelung der Temperiereinheit mit einem Hohlraum ist, durch den das Kühlgas oder die Kühlflüssigkeit geleitet werden kann.

In einer weiteren Ausgestaltung ist zumindest eine der Energiequellen in einer Umhüllung angeordnet, die für die elektromagnetischen Strahlung der Energiequelle zumindest teilweise transparent ist. Beispielsweise besteht die Umhüllung aus Quarzglas. Vorzugsweise ist die Umhüllung vakuumdicht. Mit Hilfe der Umhüllung kann die Energiequelle vor einem Kontakt mit einem Prozeßgas geschützt werden. Zudem kann die Umhüllung von einem Kühlmittel durchflossen sein zur Beschleunigung eines Abkühlens der Energiequelle und damit des Prozessierguts. Ein weiterer Vorteil dieser Ausgestaltung ist ein einfaches Auswechseln der Energiequelle.

In einer besonderen Ausgestaltung weist die Umhüllung der Energiequelle einen optischen Filter für die elektromagnetische Strahlung der Energiequelle auf. Damit kann gezielt auf die optische Eigenschaft (Absorptions- und Transmissionsvermögen) der Umhüllung Einfluß genommen werden.

In einer besonderen Ausgestaltung weist zumindest eine der Temperiereinheiten zumindest einen Transparenzkörper auf, der eine bestimmte Absorption und eine bestimmte Transmission für zumindest eine der elektromagnetischen Strahlungen aufweist und der im Strahlungsfeld der elektromagnetischen Strahlung zwischen der Energiequelle der elektromagnetischen Strahlung und einem der Prozessiergüter angeordnet ist. Der besondere Vorteil des Transparenzkörpers insbesondere beim Temperieren eines Mehrschichtkörpers ist weiter unten im Zusammenhang mit der Ausgestaltung der Temperiereinheit ausgeführt.

In einer besonderen Ausgestaltung weist die Umhüllung der Energiequelle, der Temperierbehälter, die Temperierkammer der Transparenzkörper und/oder ein Reflexionskörper ein Material auf, das gegenüber dem Gas inert ist. Insbesondere ist das Material aus der Gruppe Glas, Quarzglas, Quarzgut, Keramik, Glaskeramik und/oder Metall ausgewählt. Diese Materialien sind gegenüber einer Vielzahl von Prozeßgasen inert, d.h. reaktionsträge. Zudem haben einige Materialien wie Quarzglas oder Glaskeramik einen niedrigen Temperaturausdehungskoeffizienten. Dies ist bei einer Vorrichtung besonders wichtig, die aus Bestandteilen aus verschiedenen Materialien zusammengesetzt ist. Innerhalb einer zulässigen Toleranz kann sich eine Abmessung eines Bestandteils ändern. Dies gewährleistet, daß die Vorrichtung während des Temperierens nicht aufgrund einer mechanischen Spannung zerstört wird, d.h. erhalten bleibt. Außerdem ist dadurch eine Kontrolle einer Gasatmosphäre leichter möglich. Ein möglicher Spalt eines Bestandteils oder zwischen den Bestandteilen der Vorrichtung ändert sich durch den niedrigen thermischen Ausdehnungskoeffizienten seiner Bestandteile während des Temperierens kaum. Ein zusätzlicher Vorteil ergibt sich durch eine Verwendung eins maschinenbearbeitbaren Materials (z.B. maschinenbearbeitbare Keramik, Glaskeramik oder maschinenbearbeitbares Quarzgut).

Im folgenden wird beschrieben, wie durch verschiedene Ausgestaltungen der Temperiereinheit gewährleistet wird, daß großflächige Prozessiergüter, insbesondere Mehrschichtkörper mit einer unsymmetrischen Schichtfolge, temperiert werden können unter Steuerung einer Temperaturhomogenität des Prozessierguts.

Das Prozessiergut der Temperiereinheit ist beispielsweise ein Mehrschichtkörper, der eine erste Schicht und mindestens eine zweite Schicht aufweist. Die Temperierung erfolgt durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht. Die Temperiereinheit, die mindestens eine Energiequelle der Energiemenge aufweist, ist dadurch gekennzeichnet, daß die erste Schicht zwischen einer ersten Energiequelle und der zweiten Schicht und die zweite Schicht zwischen einer zweiten Energiequelle und der ersten Schicht angeordnet ist. Mindestens eine der Energiequellen weist eine Emission einer bestimmten elektromagnetischen Strahlung mit einem Strahlungsfeld auf und mindestens eine der Schichten weist eine bestimmte Absorption für diese elektromagnetische Strahlung auf und ist in dem Strahlungsfeld angeordnet. Darüber hinaus ist in dem Strahlungsfeld zwischen der Energiequelle mit dem Strahlungsfeld und der Schicht, die die Absorption der elektromagnetischen Strahlung aufweist und die im Strahlungsfeld angeordnet ist, mindestens ein Transparenzkörper angeordnet, der eine bestimmte Transmission und eine bestimmte Absorption für die elektromagnetische Strahlung aufweist.

Mit Hilfe des Transparenzkörpers gelingt es, die Schichten des Mehrschichtkörpers individuell aufzuheizen, d.h. die Teilmenge der Energiemenge, die eine Schicht aufnimmt, gezielt zu steuern, zu regulieren und/oder voreinzustellen. Beispielsweise wird eine Energiemenge mit Hilfe eines Regelkreises während des Temperierens bestimmt (siehe unten). Denkbar ist auch, daß eine Voreinstellung der Energiequellen (z.B. Energiedichte, Art der Energie, etc.) ohne einen zusätzlichen Regelkreis ausreicht. Es ist ein individuelles Aufheizen der Schichten des Mehrschichtkörpers auch bei sehr hohen Aufheizraten von 1°C/s bis beispielsweise 100°C/s und mehr möglich. Durch das individuelle Aufheizen gelingt es, während des Temperierens eine mechanische Spannung und eine damit unter Umständen auftretende Verformung des Mehrschichtkörpers möglichst klein zu halten.

Basis dafür ist der Transparenzkörper, der optisch teildurchlässig (semitransparent) ist. Durch die Transmission, die beispielsweise bei einer bestimmten Wellenlänge zwischen 0,1 und 0,9 liegt, gelangt die oben beschriebene elektromagnetische Strahlung durch den Transparenzkörper auf eine Schicht. Die Schicht kann eine entsprechende Energiemenge bzw. Teilmenge der Energiemenge aufnehmen, die direkt von der Energiequelle ausgesendet wird.

Der Transparenzkörper weist auch eine gewisse Absorption für die elektromagnetische Strahlung auf. Die damit aufgenommenen Energie kann in Form von Wärmestrahlung und/oder Wärmeleitung an eine Umgebung abgegeben werden. In einer besonderen Ausgestaltung verfügt die Vorrichtung zum Temperieren eines Mehrschichtkörpers einen Transparenzkörper, der durch die Absorption der elektromagnetischen Strahlung eine Wärmestrahlung und/oder Wärmeleitung in Richtung des Mehrschichtkörpers aufweist. Somit gelingt es, eine Schicht durch Wärmestrahlung und/oder Wärmeleitung zu temperieren.

Denkbar ist auch, daß eine erste Schicht des Mehrschichtkörpers, die für die Wärmestrahlung eine Transmission zeigt, im wesentlichen nur durch Wärmeleitung temperiert wird, während eine zweite Schicht desselben Mehrschichtkörpers durch die Wärmestrahlung desselben Transparenzkörpers im wesentlichen temperiert wird. Eine erste Schicht mit einer entsprechenden Transmission ist beispielsweise eine Schicht aus Glas. Wenn eine elektromagnetische Strahlung einer Energiequelle und/oder eines Transparenzkörpers auf den Glaskörper trifft, wird ein geringer Anteil der Strahlung (etwa 4%) reflektiert. Der größte Anteil (>90%) gelangt mehr oder weniger ungehindert durch das Glas und trifft dann auf eine zweite Schicht des Mehrschichtkörpers. Dort kann diese Strahlung absorbiert werden und zu einer Aufnahme einer Energiemenge durch diese zweite Schicht führen. Die Glasschicht kann durch Strahlung bzw. Wärmestrahlung bei einer sehr hohen Aufheizrate nicht ausreichend schnell temperiert werden. Dagegen ist ein relativ schnelles Temperieren durch Wärmeleitung möglich, wenn der Transparenzkörper eine Teilmenge der Energiemenge aufnehmen und auf die Glasschicht übertragen kann.

Denkbar ist auch der Fall, daß der Transparenzkörper selbst eine Schicht des Mehrschichtkörpers ist. Der Transparenzkörper kann durch Absorption eines Teils der elektromagnetischen Strahlung eine Teilmenge der Energiemenge aufnehmen und durch die Transmission eine weitere Teilmenge der Energiemenge zur Aufnahme durch eine weitere Schicht durchlassen.

In einer besonderen Ausgestaltung der Temperiereinheit ist eine Schicht des Mehrschichtkörpers eine Trägerschicht für zumindest eine weitere Schicht des Mehrschichtkörpers. Der Mehrschichtkörper weist insbesondere eine unsymmetrische Schichtfolge auf. Beispielsweise besteht der Mehrschichtkörper aus einer einseitig beschichteten Trägerschicht. Einzelne Schichten des Mehrschichtkörpers können auch nebeneinander angeordnet sein.

In einer besonderen Ausgestaltung weist eine Schicht des Mehrschichtkörpers ein Material auf, das aus der Gruppe Glas, Glaskeramik, Keramik, Metall und/oder Kunststoff ausgewählt ist. Als Kunststoff kommt insbesondere temperaturbeständiger Kunststoff wie Teflon in Frage. Eine Schicht ist beispielsweise eine Metallfolie. Die Metallfolie kann auch als Trägerschicht fungieren.

Die Teilmenge der Energiemenge, die von einer Schicht aufgenommen wird, hängt beispielsweise von dem Absorptions-, Emissions- und/oder Reflexionsvermögen der Schicht ab. Sie hängt aber auch von der Art der Energiequelle ab und von der Art und Weise, wie die Energiemenge auf den Mehrschichtkörper bzw. auf eine Schicht des Mehrschichtkörpers übertragen wird.

Eine der Energiequellen der Temperiereinheit ist beispielsweise eine Energiequelle für thermische Energie. Dabei kann der Schicht die thermische Energie direkt zugeführt werden. Hier kommt Wärmestrahlung, Wärmeleitung und/oder Konvektion in Frage. Im Fall der Wärmestrahlung kann die Energiequelle selbst eine Quelle für Wärmestrahlung sein. Die Wärmestrahlung ist beispielsweise elektromagnetische Strahlung im Wellenlängenbereich zwischen 0,7 und 4,5 µm. Die entsprechende Schicht ist im Strahlungsfeld der Energiequelle angeordnet. Die Schicht wird von der elektromagnetischen Strahlung der Energiequelle getroffen und absorbiert zumindest teilweise die elektromagnetische Strahlung.

Möglich ist es aber auch, daß einer Schicht eine beliebige Energie zugeführt wird, die in der Schicht in thermische Energie umgewandelt wird. Beispielsweise wird eine Schicht mit hochenergetischem UV-Licht bestrahlt, das die Schicht absorbiert. Durch eine Absorption eines hochenergetischen Lichtquants gelangt ein Molekül der Schicht oder die ganze Schicht in einen elektronisch angeregten Zustand. Eine dabei aufgenommene Energie kann in thermische Energie umgewandelt werden.

Neben Wärmestrahlung und Wärmeleitung ist auch ein Temperieren einer Schicht bzw. des ganzen Körpers durch Konvektion möglich. Dabei wird ein Gas mit einer bestimmten Energie an der Schicht vorbeigeleitet, wobei das Gas die Energie an die Schicht abgibt. Vorbeigeleitetes Gas kann gleichzeitig als Prozeßgas fungieren.

Durch Wärmeleitung und/oder Konvektion kann im übrigen eine Schicht auch gekühlt werden. Dabei wird der Schicht eine negative thermische Energie zugeführt. Auf diese Weise ist es auch möglich, die Energiemengen bzw. die Teilmengen der Energiemengen zu steuern und z.B. die mechanischen Spannungen im Mehrschichtkörper zusätzlich zu beeinflussen.

In einer besonderen Ausgestaltung ist ein Energietransmitter zur Übertragung der Energiemenge auf den Mehrschichtkörper vorhanden. Der Energietransmitter fungiert als sekundäre Energiequelle. Der Energietransmitter absorbiert beispielsweise elektromagnetische Strahlung einer primären Energiequelle, z.B. einer Halogenlampe, aus einem höheren Energiebereich und konvertiert diese elektromagnetische Strahlung in Wärmestrahlung, die von der Schicht absorbiert wird.

Als Energietransmitter kann die mittelbare und/oder unmittelbare Umgebung des Mehrschichtkörpers während des Temperierens fungieren. Denkbar ist, daß ein Energietransmitter mit dem Mehrschichtkörper zum Temperieren in einem Innenraum eines Temperierbehälters angeordnet ist. Der Energietransmitter kann auch außerhalb des Temperierbehälters, beispielsweise auf einer Wandung des Temperierbehälters oder in einem Abstand zum Temperierbehälter angeordnet sein. Denkbar ist, daß der Energietransmitter eine Beschichtung des Temperierbehälters ist. Der Energietransmitter ist beispielsweise eine Graphitfolie. Der Temperierbehälter kann auch selbst die Funktion eine Energietransmitters übernehmen. Eine derartige Funktion ist beispielsweise bei einem Temperierbehälter aus Graphit gegeben. Schließlich ist der Transparenzkörper nichts anderes als ein Energietransmitter. Ebenso fungiert ein Gas bei einer Energieübertragung durch Konvektion als Energietransmitter.

Eine Energiemenge, die der Mehrschichtkörper aufnimmt, kann nicht nur von Schicht zu Schicht, sondern auch innerhalb einer Schicht unterschiedlich sein. Beispielsweise tritt während des Temperierens ein Randeffekt im Mehrschichtkörper bzw. in einer Schicht eines Mehrschichtkörpers auf. Ein Randbereich der Schicht weist eine andere Temperatur auf als ein innerer Bereich der Schicht. Es stellt sich während des Temperierens ein lateraler Temperaturgradient ein. Dies geschieht beispielsweise dann, wenn ein Strahlungsfeld der Energiequelle inhomogen ist. Dabei ist eine Energiedichte des Stahlungsfeldes auf einer Fläche, die von der Strahlung durchstrahlt wird, nicht überall gleich. Eine laterale Temperaturinhomogenität kann sich auch bei einem homogenen Strahlungsfeld einstellen, wenn am Rand einer Schicht aufgrund der größeren absorbierenden Fläche pro Volumeneinheit eine größere Energiemenge pro Volumeneinheit absorbiert wird. Um den Temperaturunterschied auszugleichen, kann beispielsweise eine Energiequelle verwendet werden, die aus einer Vielzahl von Untereinheiten besteht. Jede Untereinheit kann separat angesteuert werden und so jede von einer Untereinheit auf eine Schicht zugeführte Energiemenge separat eingestellt werden. Eine derartige Energiequelle ist beispielsweise ein Array oder eine Matrix aus einzelnen Heizelementen. Ein Heizelement ist beispielsweise eine Halogenlampe. Das Array oder die Matrix kann auch dazu benutzt werden, einen lateralen Temperaturgradienten in der Schicht herzustellen. Dadurch könnte man beispielsweise eine permanente oder transiente Verformung des Schichtkörpers gezielt erzeugen. Insbesondere für die Temperierung eines Mehrschichtkörpers, bei dem Schichten nebeneinander liegen, ist ein Array oder eine Matrix von großem Vorteil

Bezüglich der Energiequelle ist es vorteilhaft, wenn die Energiequelle bzw. die Energiequellen in einem kontinuierlichen Betrieb arbeiten. Denkbar ist aber auch, daß die Energiequellen in einem Zyklus- und/oder Pulsbetrieb die Energiemenge bzw. die Teilmengen der Energiemenge den Schichten zur Verfügung stellen. Eine derartige Energiequelle ist beispielsweise eine Energiequelle mit gepulster elektromagnetischer Strahlung. Auf diese Weise kann den Schichten zur gleichen Zeit oder in einer zeitlichen Abfolge (z.B. alternierend) eine Energiemenge zugeführt werden.

Folgende Eigenschaften einer Energiequelle für elektromagnetische Strahlung sind besonders vorteilhaft:
- Die Energiequelle weist ein homogenes Strahlungsfeld auf.
- Eine spektrale Intensitätsverteilung der Energiequelle überlappt teilweise mit einer spektralen Absorption der Schicht, des Transparenzkörpers und/oder eines eventuell vorhandenen Temperierbehälters (siehe unten).
- In Gegenwart eines Prozeßgases ist die Energiequelle korrosionsfest und/oder korrosionsgeschützt.
- Die Energiequelle weist eine hohe Energiedichte auf, die ausreicht, um eine Masse des Mehrschichtkörpers (und eventuell die eines Temperierbehälters) mit einer Aufheizrate von über 1°C/s aufheizen zu können.

In einer besonderen Ausgestaltung weist der Transparenzkörper der Vorrichtung mindestens einen Abstandshalter auf, an dem der Mehrschichtkörper anliegt, zur Aufnahme einer lateral homogenen Energiemenge durch den Mehrschichtkörper. Beispielsweise wird der Schicht, über die der Mehrschichtkörper auf dem Transparenzkörper bzw. dem Abstandshalter aufliegt, in erster Linie durch eine homogene Wärmestrahlung temperiert. In dieser Form weist der Abstandshalter vorzugsweise ein Material auf, das eine geringe Absorption für die elektromagnetische Strahlung aufweist. Ein Abstandshalter überragt beispielsweise eine Oberfläche des Transparenzkörpers um einige µm bis mm.

Die auf den Abstandshaltern aufliegende Schicht kann auch in erster Linie durch Wärmeleitung temperiert werden. Dazu verfügen die Abstandshalter beispielsweise über eine für eine entsprechende Temperierrate notwendige thermische Leitfähigkeit. Denkbar ist auch, daß der Abstandshalter für die Energieübertragung durch Wärmeleitung eine hohe Absorption für eine elektromagnetische Strahlung einer Energiequelle aufweist, wobei die elektromagnetische Strahlung effizient in thermische Energie umgewandelt wird.

Insbesondere weist der Transparenzkörper eine Vielzahl von Abstandshaltern auf. Bei einer Vielzahl von Abstandshaltern, die gleichmäßig zwischen der Schicht des Mehrschichtkörpers und dem Transparenzkörper berührend angeordnet sind, kann zusätzlich eine Homogenisierung der lateralen Temperaturverteilung erreicht werden.

In einer besonderen Ausgestaltung weist der Transparenzkörper und/oder der Abstandshalter ein Material auf, das aus der Gruppe Glas und/oder Glaskeramik ausgewählt ist. Glaskeramik weist verschiedene Vorteile auf:
- Es kann zum Temperieren in einem weiten Temperaturbereich von beispielsweise 0°C bis z.B. 700°C eingesetzt werden. Glaskeramik weist beispielsweise einen Erweichungspunkt auf, der über dem Temperaturbereich liegt.
- Es verfügt über einen sehr niedrigen thermischen Ausdehnungskoeffizienten. Es ist temperaturschockbeständig und im oben erwähnten Temperaturbereich des Temperierens verwerfungsfrei.
- Es ist gegenüber einer Vielzahl von Chemikalien chemisch inert und weist eine geringe Durchlässigkeit für diese Chemikalien auf. Eine derartige Chemikalie ist beispielsweise das Prozeßgas, dem eine Schicht und/oder der ganze Mehrschichtkörper während des Temperierens ausgesetzt ist.
- Es ist im Spektralbereich vieler Energiequellen für elektromagnetische Strahlung optisch teildurchlässig, insbesondere in einem Wellenlängenbereich, in dem eine Strahlungsdichte der Energiequellen hoch ist. Eine derartige Strahlungsquelle ist beispielsweise eine Halogenlampe mit einer hohen Strahlungsdichte zwischen 0,1 und 4,5 µm.

Glas, insbesondere Quarzglas ist als Material für den Transparenzkörper ebenfalls denkbar. Vorteilhaft daran ist eine hohe Einsatztemperatur von bis zu 1200°C. Diese Materialien zeigen im Spektralbereich einer Energiequelle in Form einer Halogenlampe eine hohe Transmission und eine geringe Absorption. Das Licht tritt im wesentlichen ungehindert durch diesen Transparenzkörper hindurch und gelangt an eine Schicht mit einer entsprechenden Absorption für die elektromagnetische Strahlung, wobei die Schicht eine Energiemenge aufnimmt und erwärmt wird. Der Transparenzkörper wird durch die Strahlung nahezu nicht erwärmt.

In einer Prozeßanwendung ist es möglich, daß Material der erwärmten Schicht verdampft und an einer relativ kalten Oberfläche des Transparenzkörper abgeschieden wird. Um dies zu verhindern, kann dafür gesorgt werden, daß der Transparenzkörper während des Temperierens auf eine nötige Temperatur erwärmt wird. Dies gelingt durch eine Übertragung einer Energiemenge auf den Transparenzkörper durch Wärmeleitung und/oder Konvektion. Denkbar ist auch eine elektromagnetische Strahlung, die der Transparenzkörper absorbiert. Denkbar ist, daß der Transparenzkörper eine Beschichtung aufweist, die einen bestimmten Teil der elektromagnetischen Strahlung absorbiert. Die dadurch aufgenommene Energie kann an den Transparenzkörper aus Glas oder Quarzglas weitergeleitet werden. In dieser Form ist der Transparenzkörper, bestehend aus dem Glaskörper mit der Beschichtung, optisch teildurchlässig und kann sowohl zur Energieübertragung durch Wärmestrahlung als auch durch Wärmeleitung auf den Mehrschichtkörper eingesetzt werden.

In einer besonderen Ausgestaltung steht mindestens eine Schicht des Mehrschichtkörpers mit einem Prozeßgas in Kontakt. Denkbar ist auch, daß der ganze Mehrschichtkörper dem Prozeßgas ausgesetzt ist. Als Prozeßgas kommt beispielsweise ein Inertgas (molekularer Stickstoff oder Edelgas) in Frage. Das Prozeßgas reagiert nicht mit einem Material der Schicht. Denkbar ist aber auch ein Prozeßgas, das mit einem Material der Schicht reagiert. Unter Einwirken des Prozeßgases bildet sich die funktionelle Schicht. Beispielsweise wirkt das Prozeßgas gegenüber einem Material der Schicht oxidierend oder reduzierend. Mögliche Prozeßgase dafür sind Sauerstoff, Chlor, Wasserstoff, elementares Selen, Schwefel oder ein Hydrid. Es kann auch ein ätzendes Prozeßgase wie HCl oder ähnliches sein. Weitere Beispiele für das Prozeßgas sind H₂S und H₂Se, die bei der Herstellung einer Dünnfilmsolarzelle eingesetzt werden (siehe unten). Schließlich sind alle Gase oder auch Gasgemische denkbar, die in einer entsprechenden Weise mit einem Material einer Schicht reagieren.

Vorteilhaft ist es, wenn die Schicht einer definierten Prozeßgasatmosphäre ausgesetzt ist. Die definierte Prozeßgasatmosphäre umfaßt beispielsweise einen Partialdruck des oder der Prozeßgase während des Temperierens. Denkbar ist beispielsweise auch, daß eine Schicht oder der Mehrschichtkörper zum Temperieren mit Vakuum in Kontakt steht.

Eine definierte Prozeßgasatmosphäre läßt sich beispielsweise dadurch erreichen, daß das Prozeßgas mit einer bestimmten Geschwindigkeit an der Schicht vorbeigeleitet wird. Dabei kann ein Prozeßgas mit verschiedenen Partialdrücken im Verlauf des Temperierens auf die Schicht einwirken. Denkbar ist auch, daß nacheinander verschiedene Prozeßgase mit der Schicht des Schichtkörpers in Kontakt stehen.

Vorzugsweise ist zumindest die Schicht umschlossen, die mit dem Prozeßgas in Kontakt steht. Dies gelingt beispielsweise durch eine Umhüllung der Schicht, wobei die Umhüllung an der Trägerschicht befestigt sein kann. Die Umhüllung wird vor oder während des Temperierens mit dem Prozeßgas befüllt. Das Prozeßgas wird dabei auf einer Oberfläche der Schicht konzentriert, deren Eigenschaften durch das Prozeßgas beeinflußt werden soll. Auf diese Weise kann verhindert werden, daß eine Umgebung durch das Prozeßgas kontaminiert wird. Dies ist insbesondere bei einem korrosiven und/oder giftigen Prozeßgas wichtig. Außerdem kann mit einer für eine Umsetzung der Schicht nötigen stöchiometrischen Menge an Prozeßgas gearbeitet werden. Es wird Prozeßgas nicht unnötig verbraucht.

In einer besonderen Ausgestaltung ist der Mehrschichtkörper in einem Temperierbehälter angeordnet. Dabei weist zumindest eine Behälterwandung des Temperierbehälters einen Transparenzkörper auf. Der Temperierbehälter hat den Vorteil, daß er automatisch die Umhüllung des Schicht bzw. den ganzen Mehrschichtkörpers darstellt. Die Umhüllung braucht nicht am Mehrschichtkörper befestigt sein. Bei einem verschließbaren Temperierbehälter kann die Prozeßgasatmosphäre gezielt und leicht eingestellt werden. Beispielsweise bietet der Temperierbehälter ein genügen großes Volumen für das während des Temperierens benötigte Prozeßgas. Wenn das Temperieren eine homogene und reproduzierbare Verteilung des Prozeßgases über einer Schicht erfordert, kann auch gezielt ein Gasaustritt aus dem Temperierbehälter eingestellt werden. Dies kann beispielsweise dann nötig sein, wenn mit einer sehr hohen Aufheizrate temperiert wird. Dabei expandiert das Prozeßgas. Wenn der Temperierbehälter dem dabei auftretenden Gasdruck nicht standhält, kommt es zu einer Verformung des Temperierbehälters oder sogar zur Zerstörung des Temperierbehälters. Eine Verformung sollte aber beispielsweise dann verhindert werden, wenn der Mehrschichtkörper auf dem Boden des Temperierbehälters aufliegt. Ein Verformung des Temperierbehälters kann zu einer lateralen Temperaturinhomogenität im Mehrschichtkörper führen.

Der Temperierbehälter kann zudem Transportmittel des Mehrschichtkörpers beim Temperieren sein. Der Temperierbehälter hat den Vorteil, daß während des Temperierens beispielsweise ein Bruch einer Schicht (Trägerschicht bzw. Substrat) aus Glas nicht ausgeschlossen werden kann. Bei einem Bruch eines solchen Substrats kann das zerbrochene Material leicht aus der Temperiereinheit bzw. aus der Vorrichtung zum Temperieren entfernt werden. Dies trägt zu einer Prozeßstabilisierung des Temperierens bei.

In einer besonderen Ausgestaltung ist die Behälterwandung des Temperierbehälters, die den Transparenzkörper aufweist, ein Deckel und/oder ein Boden des Temperierbehälters. Beipielsweise liegt der Mehrschichtkörper mit eine Schicht direkt auf dem Transparenzkörper des Bodens auf. Der Transparenzkörper kann, wie oben beschrieben, Abstandshalter aufweisen. Der Deckel weist ebenfalls den Transparenzkörper auf, der beispielsweise nicht mit dem Mehrschichtkörper bzw. einer Schicht des Mehrschichtkörpers in Kontakt steht. Auf diese Weise kann die Schicht des Mehrschichtkörpers, die auf dem Boden aufliegt durch Wärmeleitung, die dem Deckel zugewandte Schicht durch Wärmestrahlung aufgeheizt werden. Die dem Deckel zugewandte Schicht kann leicht einem Prozeßgas ausgesetzt sein.

In einer weiteren Ausgestaltung ist der Boden und/oder der Deckel des Temperierbehälters von jeweils mindestens einem Mehrschichtkörper gebildet. Dabei ist die Schicht des Mehrschichtkörpers, die z.B. mit einem Prozeßgas in Berührung kommen soll, in einen Innenraum des Temperierbehälters gerichtet. Diese Lösung ist möglich, wenn der Mehrschichtkörper bzw. die Schichten des Mehrschichtkörpers einen niedrigen Temperaturausdehungskoeffizienten aufweisen und/oder die Temperierrate gering ist. Für eine hohe Temperierrate verfügt der Mehrschichtkörper vorteilhaft über eine Trägerschicht mit einem hohen thermischen Leitfähigkeitskoeffizienten. Die Trägerschicht ist nach außen gerichtet. Beispielsweise ist hier die Trägerschicht ein oben beschriebener Transparenzkörper.

In einer besonderen Ausgestaltung weist der Temperierbehälter, der Transparenzkörper und/oder der Energietransmitter ein Material auf, das gegenüber einem Prozeßgas inert ist. Vorteilhaft ist überdies, daß eine gesamte Prozeßumgebung des Temperierens inert gegenüber dem verwendeten Prozeßgas ist. Zur Prozeßumgebung zählt beispielsweise auch die Energiequelle (primäre Energiequelle).

Das Material wird in Abhängigkeit vom Prozeßgas gewählt. Denkbar ist beispielsweise Glas, Glaskeramik und Keramik. Ein faserverstärktes Material wie kohlefaserverstärkter Graphit kann ebenso verwendet werden. Denkbar ist auch ein Material wie SiC, das einen hohen thermischen Leitfähigkeitskoeffizienten aufweist. Der Temperierbehälter kann aus einem Metall oder einer Legierung bestehen. Ebenso ist ein bis zu einer bestimmten Temperatur beständigen Kunststoff möglich.

Neben einer chemischen Inertheit gegenüber dem Prozeßgas sind folgende Eigenschaften für das Material des Temperierbehälters von Vorteil:
• Das Material des Temperierbehälters ist unter den Bedingungen des Temperierens verwerfungsfrei. Es ist außerdem temperaturschockbeständig. Dies ist insbesondere dann der Fall, wenn es einen geringen Temperaturausdehnungskoeffizienten aufweist.
• Der thermische Erweichungspunkt des Materials des Temperierbehälters liegt über einer maximalen Temperatur des Temperierens.
• Der Temperierbehälter zeigt eine geringe bzw. definierte Permeabilität gegenüber einem Prozeßgas.

In einer besonderen Ausgestaltung ist eine Einrichtung zur Detektion eines Ausmaßes zumindest eines vom Temperieren abhängigen physikalischen Parameters der Vorrichtung und/oder einer Temperiereinheit zur Regelung der ersten und zweiten Teilmenge der Energiemenge vorhanden.

Ein denkbarer Parameter ist eine Absorptions-, Transmissions- und/oder Reflexionseigenschaft einer Schicht. Das Ausmaß des Parameters ist der Wert des Parameters. Beispielsweise kann eine Wellenlänge eines Absorptionsmaximums von der Temperatur abhängen. Das Ausmaß des Parameters wäre in diesem Fall die entsprechende Wellenlänge.

Insbesondere ist der Parameter eine Temperatur des Mehrschichtkörpers. Dabei ist das Ausmaß ein Wert der Temperatur. Denkbar ist auch die Detektion der Temperatur einer Schicht des Mehrschichtkörpers, des Transparenzkörpers und/oder des Temperierbehälters bzw. einer Behälterwandung des Temperierbehälters. Es kann während des Temperierens ständig zumindest ein Parameter des Mehrschichtkörpers und/oder einer Schicht detektiert werden. Beispielsweise wird aufgrund der detektierten Temperatur einer Schicht die Teilmenge der Energiemenge erhöht oder erniedrigt, die von der Schicht aufgenommen wird. Dadurch kann eine Temperaturinhomogenität bzw. ein Temperaturgradient in Dickenrichtung des Mehrschichtkörpers vermieden werden. Diese Temperaturinhomogenität kann aber auch, falls dies nötig sein sollte, erhöht werden

Beispielsweise ist die Einrichtung zur Detektion der Temperatur ein Pyrometer, der auf die Schicht gerichtet ist. Das Pyrometer detektiert beispielsweise die Wärmestrahlung, die von der Schicht ausgesendet wird. Aufgrund der Wärmestrahlung kann auf die Temperatur der Schicht rückgeschlossen werden. Denkbar ist auch ein Temperaturdetektor, der mit der Schicht verbunden ist und durch Wärmeleitung temperiert wird.

Vorstellbar ist auch, daß die Temperatur der Schicht oder des Mehrschichtkörpers nicht unmittelbar gemessen, sondern mittelbar gemessen wird. Beispielsweise wird ein Pyrometer auf den Temperierbehälter gerichtet, in dem der Mehrschichtkörper temperiert wird. Die Temperatur des Temperierbehälters kann durch die Temperatur des Mehrschichtkörpers beeinflußt sein. Aufgrund der Temperatur des Temperierbehälters wird auf die Temperatur der Schicht des Mehrschichtkörpers rückgeschlossen. Es wird die Energiemenge bzw. die Teilmenge der Energiemenge aufgrund der gemessenen Temperatur des Temperierbehälters geregelt. Dazu ist beispielsweise vor dem Temperieren eine Art "Eichmessung" durchzuführen, die einen Zusammenhang zwischen gemessener Temperatur der Temperierbehälters und tatsächlicher Temperatur der Schicht bzw. des Schichtkörpers wiedergibt. Die "Eichmessung" gibt einen Soll-Wert der Temperatur an. Der Ist-Wert wird detektiert. Ein Vergleich zwischen Soll-Wert und Ist-Wert liefert eine Regelungsgröße zur Regelung der Energiemengen. Die Detektion (und auch die Regelung der Teilmengen der Energiemenge) erfolgt insbesondere mit einer örtlichen Auflösung in Dickenrichtung des Mehrschichtkörpers und mit einer zeitlichen Auflösung im zeitlichen Rahmen des Temperierens. Beispielsweise wird der Mehrschichtkörper mit einer Temperierrate von 25°C/s aufgeheizt. Dann würden sowohl die Detektion als auch die Regelung der Teilmengen der Energiemenge so schnell stattfinden, daß ein Temperaturunterschied zwischen den Schichten des Mehrschichtkörpers während des Temperierens beispielsweise unter einen vorgeschriebenen Maximum bleibt.

Die Temperaturinhomogenität in Dickenrichtung kann in Verbindung mit einer transienten Verformung des Mehrschichtkörpers auch zu einer lateralen Temperaturinhomogenität im Mehrschichtkörper führen. Lateral bedeutet beispielsweise innerhalb einer Schicht des Mehrschichtkörpers senkrecht zur Dikkenrichtung. Beispielsweise liegt der Mehrschichtkörper auf einem Boden aus Graphit auf. Die Zufuhr bzw. die Aufnahme der Energiemenge durch die auf dem Boden aufliegenden Schicht des Mehrschichtkörpers erfolgt durch Wärmeleitung. Durch eine Temperaturinhomogenität in Dickenrichtung kann eine transiente Verformung des Mehrschichtkörpers in Form einer Verbiegung des Mehrschichtkörpers auftreten. Dabei wird der für die Wärmeleitung notwendige Kontakt zwischen dem Mehrschichtkörper und dem Boden des Temperierbehälters teilweise gelöst. Infolge davon kommt es zu einer lateralen Temperaturinhomogenität der aufliegenden Schicht bzw. des Mehrschichtkörpers. Besonders vorteilhaft ist es daher, wenn zur Detektion des Parameters (und Regelung der Energiemengen) nicht nur in Dickenrichtung, sondern auch lateral eine örtliche Auflösung vorliegt.

In einer besonderen Ausgestaltung ist der Parameter eine Verformung des Mehrschichtkörpers. Aufgrund einer auftretenden Temperaturinhomogenität kann es zu einer Verformung kommen. Beispielsweise wird der Mehrschichtkörper konkav gekrümmt. Der Mehrschichtkörper liegt auf dem Boden beispielsweise eines Temperierbehälters auf. Durch eine konkave Verformung entsteht im Randbereich des Mehrschichtkörpers ein Abstand zwischen der Auflagefläche und dem Mehrschichtkörper. Ein Ausmaß einer derartigen Verformung kann beispielsweise mit einer Einrichtung zur Laserinterferometrie oder Laserlichtreflexion detektiert werden. Aufgrund des Ausmaßes findet die Regelung der Energiemengen statt. Vorteilhaft ist es, wenn das Ausmaß in einem frühen Stadium der Verformung erkannt wird und schnell darauf regiert werden kann.

Für eine angesprochene Einrichtung zur Detektion eines Ausmaßes eine vom Temperieren abhängigen Parameters mit Hilfe einer optischen Einrichtung (z.B. Laser) ist es vorteilhaft, wenn die zu untersuchende Schicht für Licht der optischen Einrichtung zugänglich ist und ein Detektionssignal eindeutig dem zu detektierenden Parameter zuzuordnen ist. Die Wellenlänge eines Lasers sollte sich beispielsweise hinreichend von der Wärmestrahlung des Mehrschichtkörpers unterscheiden. Wenn die Vorrichtung mit einem Temperierbehälter ausgestattet ist, wäre es vorteilhaft, wenn der Transparenzkörper für das Licht des Lasers genügend durchlässig ist.

Mit Hilfe der Vorrichtung ist es auch möglich, eine gewünschte Verformung des Mehrschichtkörpers zu erzielen. Dazu kann es auch sinnvoll sein, die Verformung während des Temperierens wie oben beschrieben zu verfolgen. Es kann zum Beispiel eine gekrümmte Dünnfilmsolarzelle hergestellt werden. Zur gezielten Verformung wird beispielsweise der Mehrschichtkörper auf eine entsprechende Form bzw. Maske gelegt. Die Form bzw. Maske kann direkt eine Energiequelle sein. Der Mehrschichtkörper wird über einen Erweichungspunkt der Trägerschicht erwärmt. Als Folge davon nimmt der Mehrschichtkörper eine entsprechende Form der Maske bzw. der Form an. Die Maske ist beispielsweise in einem Boden des Temperierbehälters integriert. Die Maske könnte z.B. der Transparenzkörper sein.

Zur Lösung der Aufgabe wird neben der Vorrichtung ein Verfahren zum Temperieren eines Prozessierguts unter einer bestimmten Prozeßgasatmosphäre eines Prozeßgases nach Anspruch 2 angegeben.

Der Zwischenraum mit dem weiteren Gas, beispielsweise einem Spülgas, fungiert als Puffer, so daß das Prozeßgas, das sich im Temperierraum befindet, nicht oder nur verdünnt an die Temperierkammer gelangt. Eine Kontamination bzw. Korrosion der Temperierkammer kann unterbunden werden. Die Auswahl des Materials der Temperierkammer ist nahezu unabhängig von dem Prozeßgas. Der Zwischenraum kann einmalig mit dem Spülgas befüllt werden. Denkbar ist auch, daß durch den Zwischenraum ein kontinuierlicher Spülgasstrom geleitet wird, der eventuell aus dem Temperierbehälter austretendes Prozeßgas aus dem Zwischenraum entfernt. Der Spülgasstrom wird durch den Druckgradienten erzeugt. Ein Entfernen austretenden Prozeßgases gelingt auch dadurch, daß vom Temperierraum des Temperierbehälters zum Zwischenraum hin ein Druckgefälle erzeugt wird.

In dem Verfahren werden ein Gasdruck des Temperierraums und ein Gasdruck des Zwischenraums und ein Gasdruck des Pufferraums eingestellt, so dass ein Gasdruck des Temperierraums kleiner ist als der Gasdruck des Zwichenraums und daß ein Gasdruck des Pufferraums ausgewählt wird, der kleiner ist als der Gasdruck des Temperierraums und der kleiner ist als der Gasdruck des Zwischenraums.

Auf diese Weise kann beispielsweise zwischen dem Temperierraum und dem Zwischenraum ein Druckgradient eingestellt werden. Dies gelingt dadurch, daß die Temperierkammer in einer Umhüllung angeordnet ist.

In einer weiteren Ausgestaltung umfaßt das Temperieren mindestens ein Aufheizen und/oder mindestens ein Abkühlen. Dabei können insbesondere mehrere Aufheiz- und Abkühlphasen durchlaufen werden.

Gemäß einer weiteren Ausgestaltung wird als Prozessiergut ein Mehrschichtkörper mit einer Schicht und mindestens einer weiteren Schicht verwendet wird.

Dabei wird insbesondere ein Mehrschichtkörper mit einer Schicht verwendet, die Kupfer, Indium, Gallium und/oder Selen aufweist. Ein Trägerschicht des Mehrschichtkörper ist insbesondere aus Glas und/oder Metall.

In einer besonderen Ausgestaltung wird ein Prozeßgas verwendet, das aus der Gruppe H₂S, H₂Se, H₂, He und/oder N₂ ausgewählt ist.

Insbesondere wird ein weiteres Gas verwendet, das aus der Gruppe N₂ und/oder Edelgas ausgewählt ist.

Das Verfahren eignet sich insbesondere zur Herstellung eines photovoltaischen Dünnschicht-Chalkopyritabsorbers einer Solarzelle und/oder eines Solarmodules.

Ein Herstellen der Prozeßgasatmosphäre und der weiteren Gasatmosphäre kann vor während oder nach dem Temperieren erfolgen. Der Prozessiergüter kann dabei gleichzeitig mit mehreren Prozeßgasen (Gasgemisch) in Kontakt gebracht werden. Denkbar ist auch, daß das Prozessiergut nacheinander mit verschiedenen Prozeßgasen und/oder Spülgasen in Kontakt gebracht wird. So ist ein variables Prozeßgasprofil

(zeitliche Abfolge von verschiedenen Partialdrucken des oder der Prozeßgase) möglich. Auf diese Weise ist es beispielsweise möglich, sowohl oxidierende als auch reduzierende Prozeßgase einzusetzen oder gezielt einen Dotierstoff in das Prozessiergut einzubringen.

In der Erfindung ist eine Umhüllung des Temperierbehälters vorhanden, so daß zwischen dem Zwischenraum und dem Temperierraum ein Pufferraum für Gas vorhanden ist.

Im Zwischenraum zwischen Temperierkammer und dem Temperierbehälter wird ein Gasdruck eines Spülgases erzeugt, der größer ist als der Gasdruck im Pufferraum. Vorzugsweise sind dazu in der Umhüllung Gasausauslaßöffnungen angebracht, die beispielsweise über eine Sammelrohrleitung durch den Zwischenraum und durch die Temperierkammer nach außen geführt sind und dort beispielsweise in eine Gasentsorgungseinheit geleitet werden. Somit herrscht in dem Pufferraum der Umhüllung annähernd der Druck, der auch in der Gasentsorgungseinheit vorhanden ist (z.B. Atmosphärendruck). Die Wirkung dieser Anordnung kann als Spaltgegenstrom-Spülung bezeichnet werden, die dazu dient, an einem Spalt einer Durchführung der Umhüllung, beispielsweise an einer Fügespalte eines Bauteils der Umhüllung einen Inertgasgegenstrom gegen aus dem Temperrierraum ausdiffundierenden Prozeßgasstrom gegenzuhalten mit dem Ziel, eine Kondensation von Prozeßgasen an den Temperierkammerwänden oder eine Korrosion der Temperierkammerwände zu verhindern. Letzteres kann übrigens auch durch eine geeignete Beschichtung der Temperierkammerwände erreicht werden.

Die Spaltgegenstrom-Spülung gelingt nach folgendem Prinzip: In der Umhüllung ist der mit dem Prozeßgas befüllte Temperierbehälter angeordnet. Es kann nicht ausgeschlossen werden, daß das Prozeßgas in den Pufferraum der Umhüllung gelangt. Durch kleine Spalte oder Öffnungen stehen der Pufferraum der Umhüllung und der Zwischenraum zwischen Temperierbehälter und Temperierkammer in Verbindung. Durch die Wahl der Gasdrucke wird ein Druckgradient von dem Zwischenraum zum Pufferraum aufgebaut. Dies gelingt beispielsweise durch Absaugen des Spülgases des Pufferraums und/oder Einleiten des Spülgases in den Zwischenraum und einem dadurch hervorgerufenem Druckaufbau gegenüber dem Druck des Pufferraums, der wie oben beschrieben mit der Umgebung der Vorrichtung zum Temperieren in Kontakt stehen kann. Dadurch kommt es zu einem Spülgasstrom von Zwischenraum zum Pufferraum hin. Das Prozeßgas gelangt nicht an die Kammerwandung der Temperierkammer. Während des Temperierens wird dabei insbesondere eine Temperatur der Temperierkammer, der Gasdruck des Pufferraums und/oder der Gasdruck des Zwischenraums eingestellt.

In einer besonderen Ausgestaltung wird als Prozessiergut und/oder weiteres Prozessiergut ein Mehrschichtkörper mit einer Schicht und mindestens einer weiteren Schicht verwendet.

Dabei erfolgt das Temperieren durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht, wobei zumindest eine Energiequelle zum Zuführen der Energiemenge auf den Mehrschichtkörper verwendet wird. Dabei wird insbesondere eine zuvor beschriebene Vorrichtung verwendet. Die Verfahrensschritte sind: Anordnen des Mehrschichtkörpers zwischen einer ersten und mindestens einer zweiten Energiequelle, so daß die erste Schicht zwischen der ersten Energiequelle und der zweiten Schicht und die zweite Schicht zwischen der zweiten Energiequelle und der ersten Schicht angeordnet ist, wobei als Energiequelle zumindest eine Energiequelle für eine bestimmte elektromagnetische Strahlung mit einem Strahlungsfeld verwendet wird, und zumindest eine der Schichten die elektromagnetische Strahlung absorbiert und im Strahlungsfeld der Energiequelle angeordnet wird, und Anordnen eines Transparenzkörpers im Strahlungsfeld der Energiequelle zwischen der Energiequelle und der Schicht, die im Strahlungsfeld der Energiequelle liegt und die die bestimmte elektromagnetische Strahlung absorbiert und Temperieren des Mehrschichtkörpers.

In einer besonderen Ausgestaltung absorbiert der Transparenzkörper eine bestimmte Energiemenge und führt die Energiemenge der Schicht zu. In einer weiteren Ausgestaltung wird während des Temperierens ein Detektieren eines vom Temperieren abhängigen Ausmaßes eines physikalischen Parameters des Mehrschichtkörpers zur Regelung der Aufnahme der Energiemenge während des Temperierens und Regelung der ersten und zweiten Teilmengen der Energiemenge durchgeführt. In einer besonderen Ausgestaltung führt der Transparenzkörper die Schicht die Energiemenge durch Wärmeleitung und/oder Wärmestrahlung zu.

In einer besonderen Ausgestaltung wird ein Mehrschichtkörper mit einer Schicht verwendet wird, die Kupfer, Indium, Gallium und/oder Selen aufweist. Insbesondere wird ein Mehrschichtkörper mit einer Trägerschicht aus Glas und/oder Metall verwendet. Die Trägerschicht kann ihrerseits eine Beschichtung aufweisen (z.B. eine Metallschicht auf einer Glasplatte). Als Prozeßgas wird ein Gas verwendet, das aus der Gruppe H₂S, H₂Se, H₂, He und N₂ ausgewählt ist. Das Verfahren dient insbesondere der Herstellung eines photovoltaischen Dünnschicht-Chalkopyritabsorbers einer Solarzelle und/oder eines Solarmoduls. Bei dem Solarmodul ist eine Vielzahl von seriell verschalteten einzelnen Solarzellen vorhanden. Das Glas ist vorzugsweise Sodalime-Glas. Die entsprechende Schicht fungiert als Trägerschicht. Auf der Trägerschicht ist eine Molybdänschicht als Elektrode und über der Molybdänschicht eine funktionelle Schicht, nämlich eine Kupfer-Indium-Gallium-Sulfo-Selenid(CIGSSe)-Halbleiterschicht, aufgetragen. Eine Dicke des Schichtkörpers, bestehend Glaskörper und Halbleiterschicht beträgt typischerweise 2 bis 4 mm, mit einer Molybdänschicht von ca. 0,5 µm und einer Halbleiterschicht von ca. 3 µm. Der angegebene Bereich für die Dicke des Mehrschichtkörpers ist nicht ausschließend zu verwenden. Begrenzender Faktor ist eine Fähigkeit, ein großes Substrat herzustellen, das möglichst plan ist und damit mit der beschriebenen Vorrichtung bzw. mit dem beschriebenen Verfahren zu einem Mehrschichtkörper verarbeitet werden kann.

Zusammengefaßt ergeben sich mit der Erfindung folgende Vorteile:
- Es kann ein Prozessiergut in beliebiger Prozeßgasatmosphäre temperiert werden. Insbesondere kann ein toxisches und/oder korrosives Prozeßgas eingesetzt werden. Kondensationen einer Prozeßsubstanz an den Kammerwänden kann vermieden werden.

- Ein Aufheiz- und Abkühlprofil kann variabel gestaltet werden.
- Es kann ein Prozessiergut in Form eines großflächigen Mehrschichtkörper mit einem unsymmetrischen Schichtaufbau (z.B. Mehrschichtkörper mit einer einzigen Schicht auf einer Trägerschicht) mit einer hohen Temperierrate von über 1°C/s temperiert werden.
- Die Schichten des Mehrschichtkörpers können dabei einen stark unterschiedlichen thermischen Leitfähigkeitskoeffizienten und/oder ein stark unterschiedliches Emissionsvermögen aufweisen.
- Durch eine zeitliche und örtliche Auflösung der Detektion und der Regelung eines Ausmaßes eines vom Temperieren abhängigen Parameters können gelingt ein Temperieren besonders sicher. Beispielsweise kann auf eine Änderung einer Eigenschaft des Prozessierguts (z.B. Emissions- oder Absorptionsvermögen) während des Temperierens reagiert und die Prozeßparameter (Druck, Temperatur, Energiedichte, etc.) daraufhin eingestellt werden.
- Das Temperieren bis nahe eines Erweichungspunkts einer Trägerschicht des Prozessierguts ist möglich.
- Beim Temperieren über den Erweichungspunkt der Trägerschicht ist eine permanente Verformung des Mehrschichtkörpers möglich.
- Es kann eine definierte Temperierungsumgebung mit einer definierten Prozeßgasatmosphäre geschaffen werden.
   Verschiedene Prozeßgase mit verschiedenen Partialdruckprofilen können gleichzeitig oder nacheinander vor, während und/oder nach der Prozessierung eingestellt werden.
- Alle zur Prozessierung notwendigen Verfahrensstufen können mit einer einzigen Vorrichtung durchgeführt werden.

Anhand mehrerer Ausführungsbeispiele und der dazugehörigen Figuren wird eine Vorrichtung zum Temperieren eines Prozessierguts und ein entsprechendes Verfahren dazu vorgestellt. Die Figuren sind schematisch und stellen keine maßstabsgetreuen Abbildungen dar.
- Figur 1: zeigt einen Querschnitt einer Vorrichtung zum Tem- perieren mindestens eines Prozessierguts von der Seite.
- Figur 2: zeigt ein Verfahren zum Temperieren mindestens eines Prozessierguts.
- Figur 3: zeigt einen Ausschnitt eines Querschnitts einer Vorrichtung zum Temperieren von mindestens einem Prozessiergut von der Seite.
- Figur 4: zeigt einen Querschnitt einer Vorrichtung zum Temperieren mindestens eines Prozessierguts von der Seite.

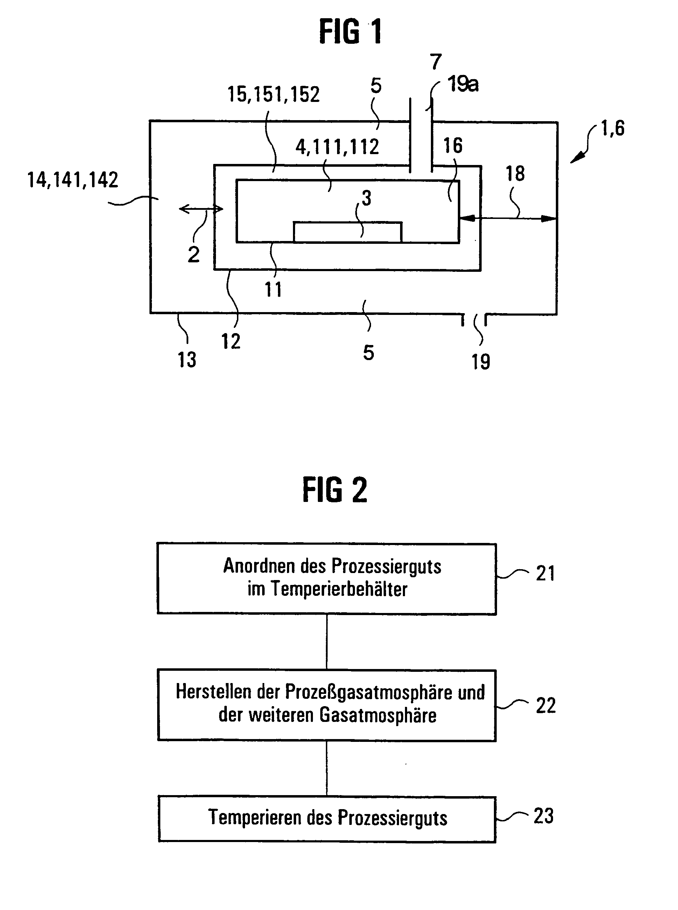

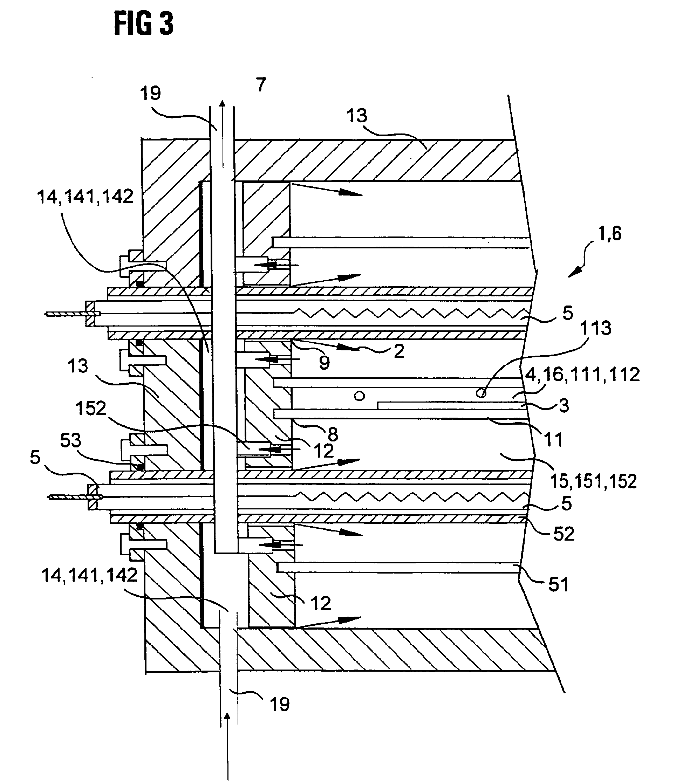

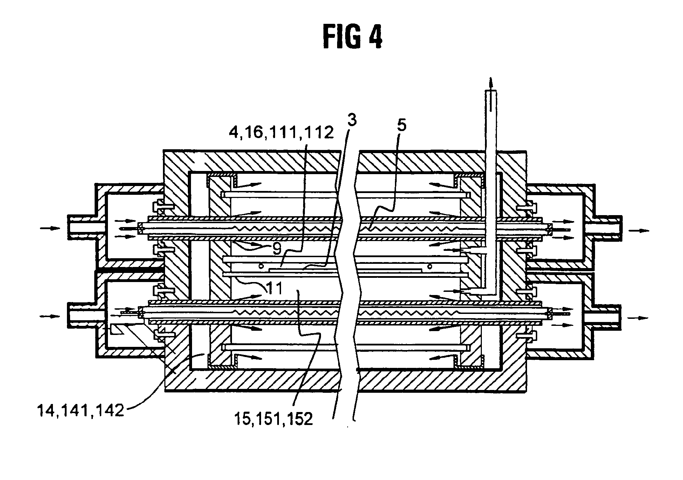

Ausgangspunkt ist eine Vorrichtung 1 zum Temperieren eines Prozessierguts 3 (Figuren 1 und 4) unter der Prozeßgasatmosphäre 111 eines Prozeßgases 4. Die Vorrichtung 1 verfügt über eine Temperiereinheit 6 mit Temperierbehälter 11, Umhüllung 12 des Temperierbehälters 11, Temperierkammer 13 und Energiequelle 5 zur Aufnahme einer Energiemenge durch das Prozessiergut 3. Der Temperierbehälter 11 wird über Prozeßgaseinlaß- und -auslaßöffnungen 113 mit dem Prozeßgas 4 befüllt (Figur 3). Der Temperierbehälter 11 liegt in einer Umhüllung 12 vor, so daß ein Pufferraum 15 zwischen Umhüllung 12 und Temperierbehälter 11 vorhanden ist. Zusammen mit der Umhüllung 12 ist der Temperierbehälter in einer evakuierbaren Temperierkammer 13 angeordnet, so daß ein Abstand 18 zwischen dem Temperierbehälter 11 und der Temperierkammer 13 vorhanden ist. Zum Herstellen der weiteren Gasatmosphäre 141 des Zwischenraums ist eine verschließbare Öffnung 19 in der Temperierkammer 13 vorhanden. Eine weitere Gasöffnung ist in der Umhüllung 12 angebracht und wird mit Rohrverbindung 19a durch die Temperierkammer 13 nach außen an die Umgebung 7 geführt.

In den Temperierbehälter 11 wird das Prozessiergut 3 im Verfahrensschritt 21 angeordnet (Figur 2). Danach findet das Temperieren (Verfahrensschritt 23) statt, wobei der Druckgradient 2 zwischen dem Pufferraum 15 der Umhüllung 12 und dem Zwischenraums 14 hergestellt wird.

In einer weiteren Ausführungsform wird der Druckgradient 2 eingestellt (Verfahrensschritt 22) und anschließend das Temperieren 23 durchgeführt. Dabei wird die Änderung des Druckgradienten während des Temperierens 23 kontrolliert.

Figur 3 verdeutlicht das Prinzip der Spaltgegenstrom-Spülung. Durch die Pfeile ist ein Druckgradient 2 bzw. ein sich daraus ergebender Gasstrom angedeutet. Während des Temperierens 23 herrscht im Temperierraum 16 des Temperierbehälters 11 eine Prozeßgasatmosphäre 111 mit dem Gasdruck 112 des Temperierraums 16. Durch einen Spalt 8 des Temperierbehälters 11 kann das Prozeßgas 4 in den Pufferraum 15 der Temperiereinheit 6 austreten. Um zu verhindern, daß die Temperierkammer 13 von dem Prozeßgas 4 kontaminiert wird, ist der Pufferraum 15 mit einer Umgebung 7 derart verbunden, daß der Gasdruck 152 (Gasatmosphäre 151) des Pufferraums 15 einem Gasdruck der Umgebung 7 entspricht. Der Gasdruck der Umgebung 7 und damit der Gasdruck 152 des Pufferraums 15 ist kleiner als der Gasdruck 112 des Temperierraums 16 und kleiner als der Gasdruck 142 des Zwischenraums 14.

Gleichzeitig wird dafür gesorgt, dass im Zwischenraum 14 zwischen der Temperierkammer 13 und dem Temperierbehälter 11 ein Gasdruck 142 herrscht, der in etwa dem Gasdruck 112 des Temperierraums 16 des Temperierbehälters 11 entspricht. Er ist etwas größer, so daß das Prozeßgas 4 durch einen Spalt 9 der Umhüllung 12 nicht in den Zwischenraum 14 gelangt. Dadurch, daß in der Umgebung 7 der im Vergleich zu den Gasdrucken 112 und 142 kleinere Gasdruck 152 herrscht, wird eventuell in den Pufferraum 15 der Umhüllung 12 austretendes Prozeßgas 4 aufgrund der herrschenden Druckgradienten 2 in Richtung Umgebung 7 transportiert.

Die Ausführungsform gemäß Figur 3 ist mit zusätzlichen Infrarot-Reflektoren 51 und Wolfram-Halogenid-Stabheiz-Lampen 5, die in Quarz-Hüllrohre 52 eingeführt sind, ausgestattet. Die Quarz-Hüllrohre 52 sind durch die Vakuumwand der Temperierkammer 13 hindurchgeführt und mit Vakuum-Dichtungen 53 gegen Atmosphäre abgedichtet.

## Patentansprüche

1. Vorrichtung zum Temperieren mindestens eines Prozessierguts (3) unter einer bestimmten Prozessgasatmosphäre (111) mindestens eines Prozessgases (4) mit Hilfe einer Temperiereinheit (6), aufweisend mindestens eine Energiequelle (5) zur Aufnahme einer Energiemenge durch das Prozessiergut (3), einen Temperierbehälter (11) mit Temperierraum (16) zum Aufbewahren des Prozessiergutes (3) unter der Prozessgasatmosphäre (111) während des Temperierens wobei der Temperierbehälter (11) in einer Umhüllung (12) vorliegt, so daβ ein Pufferraum (15) für Gas zwischen Umhüllung (12) und Temperierbehälter (11) vorhanden ist, eine Temperierkammer (13), in der in einem Abstand (18) zur Temperierkammer (13) der Temperierbehälter (11) angeordnet ist, so dass ein Zwischenraum (14) der den Temperierraum (16) umschließt zwischen Temperierbehälter (11) und Temperierkammer (13) vorhanden ist und ein Mittel (19, 191) zum Herstellen einer von der Prozessgasatmosphäre (111) verschiedenen weiteren Gasatmosphäre (141) eines weiteren Gases in dem Zwischenraum (14), wobei die weitere Gasatmosphäre (141) einen Druckgradienten (2) aufweist so dass der Gasdruck des Temperierraums (16) kleiner ist als der Gasdruck des Zwischenraums (14) und wobei der Temperierbehälter (11) und der Pufferraum (15) durch einen Spalt (8) des Temperierbehälters (11) verbunden sind, durch den das Prozessgas (4) in den Pufferraum (15) austreten kann, und der Zwischenraum (14) und der Pufferraum (15) durch einen Spalt (9) der Umhüllung (12) verbunden sind, und wobei der Pufferraum (15) mit einer Umgebung (7) derart verbunden ist, dass der Gasdruck des Pufferraums (15) einem Gasdruck der Umgebung (7) entspricht und der Gasdruck des Pufferraums (15) so eingestellt werden kann, dass er kleiner ist als der Gasdruck des Temperierraums (16) und kleiner als der Gasdruck des Zwischenraums (14).

2. Verfahren zum Temperieren eines Prozessierguts (3) unter einer bestimmten Prozessgasatmosphäre (111) eines Prozessgases (4) mit Hilfe einer Vorrichtung zum Temperieren nach Anspruch 1, wobei das Prozessiergut (3) im Temperierraum (16) des Temperierbehälters (11) angeordnet wird und zum Herstellen des Druckgradienten ein Prozess-Gasdruck des Temperierraums (11) und ein Gasdruck des Zwischenraums (14) und ein Gasdruck des Pufferraums (15) so eingestellt werden, dass ein Gasdruck des Temperierraums (11) kleiner als der Gasdruck des Zwischenraums (14) ist und dass ein Gasdruck des Pufferraums (15) ausgewählt wird, der kleiner ist als der Gasdruck des Temperierraums (16) und kleiner ist als der Gasdruck des Zwischenraums (14) und wobei das Prozessiergut (3) temperiert wird.

3. Verfahren nach Anspruch 2, bei dem als Prozessierguts (3) ein Mehrschichtkörper mit einer Schicht und mindestens einer weiteren Schicht verwendet wird.

4. Verfahren nach Anspruch 3, wobei ein Mehrschichtkörper mit einer Schicht verwendet wird, die Kupfer, Indium, Gallium und/oder Selen aufweist.

5. Verfahren nach Anspruch 3 oder 4, wobei ein Mehrschichtkörper mit einer Trägerschicht aus Glas und/oder Metall verwendet wird.

6. Verfahren nach einem der Ansprüche 3 bis 5, wobei ein Prozessgas verwendet wird, das aus der Gruppe H₂S, H₂Se, H₂, He und/oder N₂ ausgewählt ist.

7. Verfahren nach einem der Ansprüche 3 bis 6, wobei ein weiteres Gas verwendet wird, das aus der Gruppe N₂ und/oder Edelgas ausgewählt ist.

8. Verfahren nach einem der Ansprüche 3 bis 7 zur Herstellung eines photovoltaischen Dünnschicht-Chalkopyritabsorbers einer Solarzelle und/oder eines Solarmodules.

## Claims

1. Device for tempering at least one process good (3) under a specific process-gas atmosphere (111) of at least one process gas (4) using a tempering unit (6), having at least one energy source (5) for accepting an amount of energy by the process good (3), a tempering container (11) with a tempering space (16) for storing the process good (3) under the process-gas atmosphere (111) during tempering, whereby the tempering container (11) is inside a shroud (12) such that a buffer space (15) for gas is present between the shroud (12) and tempering container (11), a tempering chamber (13), in which the tempering container (11) is arranged at a distance (18) from the tempering chamber (13), such that an intermediate space (14) that surrounds the tempering space (16) is present between the tempering container (11) and the tempering chamber (13), and a means (19, 191) for producing a further gas atmosphere (141) of a further gas in the intermediate space (14) different from the process-gas atmosphere (111), whereby the further gas atmosphere (141) has a pressure gradient (2) such that the gas pressure of the tempering space (16) is less than the gas pressure of the intermediate space (14) and whereby the tempering container (11) and the buffer space (15) are connected by a gap (8) of the tempering container (11), through which the process gas (4) can enter the buffer space (15), and the intermediate space (14) and the buffer space (15) are connected by a gap (9) of the shroud (12), and whereby the buffer space (15) is connected with a surrounding area (7) such that the gas pressure of the buffer space (15) corresponds to a gas pressure of the surrounding area (7) and the gas pressure of the buffer space (15) can be set such that it is less than the gas pressure of the tempering space (16) and less than the gas pressure of the intermediate space (14).

2. Method for tempering a process good (3) under a specific process-gas atmosphere (111) of a process gas (4) using a device for tempering according to claim 1, whereby the process good (3) is arranged in the tempering space (16) of the tempering container (11), and to produce the pressure gradient, a process-gas pressure of the tempering space (11) and a gas pressure of the intermediate space (14), and a gas pressure of the buffer space (15) are set such that a gas pressure of the tempering space (11) is less than the gas pressure of the intermediate space (14) and that a gas pressure of the buffer space (15) is selected that is less than the gas pressure of the tempering space (16) and less than the gas pressure of the intermediate space (14), and whereby the process good (3) is tempered.

3. Method according to claim 2, in which a multilayered element with one layer and at least one further layer is used as the process good (3).

4. Method according to claim 3, in which a multilayered element with a layer that has copper, indium, gallium, and/or selenium is used.

5. Method according to claim 3 or 4, in which a multilayered element with a support layer made of glass and/or metal is used.

6. Method according to one of claims 3 through 5, in which a process gas that is selected from the group H₂S, H₂Se, H₂, He, and/or N₂ is used.

7. Method according to one of claims 3 through 6, in which a further gas that is selected from the group N₂ and/or noble gas is used

8. Method according to one of claims 3 through 7 for producing a photovoltaic thin-film chalcopyrite absorber of a solar cell and/or of a solar module.

## Revendications

1. Dispositif de trempe d'au moins un élément à traiter (3) sous une atmosphère gazeuse de traitement définie (111) d'au moins un gaz de traitement (4) à l'aide d'une unité de trempe (6), présentant au moins une source d'énergie (5) pour faire absorber une quantité d'énergie par l'élément à traiter (3), un récipient de trempe (11) ayant un espace de trempe (16) pour la conservation de l'élément à traiter (3) sous l'atmosphère gazeuse de traitement (11) pendant la trempe, le récipient de trempe (11) se présentant dans une enveloppe (12) de telle sorte qu'un espace tampon (15) pour le gaz soit présent entre l'enveloppe (12) et le récipient de trempe (11), une chambre de trempe (13) dans laquelle le récipient de trempe (11) est disposé à une distance (18) par rapport à la chambre de trempe (13) de telle sorte qu'un espace intermédiaire (14) qui entoure l'espace de trempe (16) soit présent entre le récipient de trempe (11) et la chambre de trempe (13) et un moyen (19, 191) pour produire une autre atmosphère gazeuse (141) différente de l'atmosphère gazeuse de traitement (111) d'un autre gaz dans l'espace intermédiaire (14), l'autre atmosphère gazeuse (141) présentant un gradient de pression (2) de telle sorte que la pression de gaz de l'espace de trempe (16) soit plus petite que la pression de gaz de l'espace intermédiaire (14) et le récipient de trempe (11) et l'espace tampon (15) étant reliés par une fente (8) du récipient de trempe (11) par laquelle le gaz de traitement (4) peut s'échapper dans l'espace tampon (15), et l'espace intermédiaire (14) et l'espace tampon (15) étant reliés par une fente (9) de l'enveloppe (12), et l'espace tampon (15) étant relié avec un environnement (7) de telle sorte que la pression de gaz de l'espace tampon (15) corresponde à une pression de gaz de l'environnement (7) et la pression de gaz de l'espace tampon (15) puisse être réglée de telle sorte qu'elle soit plus petite que la pression de gaz de l'espace de trempe (16) et plus petite que la pression de gaz de l'espace intermédiaire (14).

2. Procédé pour réaliser une trempe d'un élément à traiter (3) sous une atmosphère gazeuse de traitement définie (111) d'un gaz de traitement (4) à l'aide d'un dispositif de trempe tel que défini à la revendication 1, suivant lequel l'élément à traiter (3) est disposé dans l'espace de trempe (16) du récipient de trempe (11) et pour la production du gradient de pression, une pression de gaz de traitement de l'espace de trempe (11) et une pression de gaz de l'espace intermédiaire (14) et une pression de gaz de l'espace tampon (15) étant réglées de telle sorte qu'une pression de gaz de l'espace de trempe (11) soit plus petite que la pression de gaz de l'espace intermédiaire (14) et qu'une pression de gaz de l'espace tampon (15) soit choisie, qui est plus petite que la pression de gaz de l'espace de trempe (16) et est plus petite que la pression de gaz de l'espace intermédiaire (14), et suivant lequel l'élément à traiter (3) est trempé.

3. Procédé selon la revendication 2, suivant lequel on utilise comme élément à traiter (3) un corps multicouches ayant une couche et au moins une autre couche.

4. Procédé selon la revendication 3, suivant lequel on utilise un corps multicouches ayant une couche qui présente du cuivre, de l'indium, du gallium et/ou du sélénium.

5. Procédé selon l'une des revendications 3 ou 4, suivant lequel on utilise un corps multicouches ayant une couche de support en verre et/ou métal.

6. Procédé selon l'une des revendications 3 à 5, suivant lequel on utilise un gaz de traitement qui est choisi dans le groupe constitué par H₂S, H₂Se, H₂, He et/ou N₂.

7. Procédé selon l'une des revendications 3 à 6, suivant lequel on utilise un autre gaz qui est choisi dans le groupe constitué par N₂ et/ou un gaz rare.

8. Procédé selon l'une des revendications 3 à 7 pour la fabrication d'un absorbeur à chalcopyrite en couche mince photovoltaïque d'une cellule solaire et/ou d'un module solaire.
